**Europäisches Patentamt**

(19) **European Patent Office**

**Office européen des brevets**

(11) Publication number : **0 306 041 B1**

# (12) EUROPEAN PATENT SPECIFICATION

(45) Date of publication of patent specification :
**22.02.95 Bulletin 95/08**

(51) Int. Cl.⁶ : **H01F 1/153,** H01F 17/03, H01F 17/06, C04B 35/48, C04B 35/56, H01F 3/04

(21) Application number : **88114353.1**

(22) Date of filing : **02.09.88**

(54) **Noise suppression assembly.**

(30) Priority : **04.09.87 JP 220341/87**
**04.09.87 JP 220342/87**
**04.09.87 JP 220343/87**
**22.09.87 JP 236142/87**

(43) Date of publication of application :
**08.03.89 Bulletin 89/10**

(45) Publication of the grant of the patent :
**22.02.95 Bulletin 95/08**

(84) Designated Contracting States :
**DE FR GB**

(56) References cited :
**EP-A- 0 005 836**
**DE-A- 3 721 427**
**US-A- 4 262 233**
**US-A- 4 420 348**
**US-A- 4 637 843**
**Patent Abstracts of Japan, vol.10, no.1 (E371)**
**(2058), 27/01/86**

(73) Proprietor : **KABUSHIKI KAISHA TOSHIBA**
**72, Horikawa-cho**
**Saiwai-ku**
**Kawasaki-shi Kanagawa-ken 210 (JP)**

(72) Inventor : **Sawa, Takao c/o Kabushiki Kaisha Toshiba**
**72, Horikawa-cho**
**Saiwai-ku**
**Kawasaki-shi Kanagawa-ken (JP)**
Inventor : **Okamura, Masami c/o Kabushiki Kaisha Toshiba**
**72, Horikawa-cho**
**Saiwai-ku**
**Kawasaki-shi Kanagawa-ken (JP)**
Inventor : **Yamada, Taiju c/o Kabushiki Kaisha Toshiba**
**72, Horikawa-cho**
**Saiwai-ku**
**Kawasaki-shi Kanagawa-ken (JP)**
Inventor : **Kusaka, Takao c/o Kabushiki Kaisha Toshiba**
**72, Horikawa-cho**
**Saiwa-ku**
**Kawasaki-shi Kanagawa-ken (JP)**
Inventor : **Sasaki, Hiroshi c/o Kabushiki Kaisha Toshiba**
**72, Horikawa-cho**
**Saiwai-ku**
**Kawasaki-shi Kanagawa-ken (JP)**

(74) Representative : **Lehn, Werner, Dipl.-Ing. et al**
**Hoffmann, Eitle & Partner,**
**Patentanwälte,**
**Postfach 81 04 20**
**D-81904 München (DE)**

## Description

This invention relates to noise suppression assembly comprising a noise suppression device, and more particularly a device effective for suppressing generation of noise from a circuit by externally fitting it on a line in semiconductor circuits such as switching electric source circuits or a lead of all sorts of devices such as rectifiers and capacitors.

Semiconductor circuits as exemplified by switching electric source circuits that control a large electric current in a high frequency region have for a long time had the problem that a current spike or ringing tends to be produced owing to the properties of semiconductors themselves used there or other factors in the circuits. There is a possibility that these phenomena mentioned above impede normal operation of circuits, finally resulting in destruction of semiconductors themselves.

Moreover, the above abrupt changes that occurred in circuits according to switching operation may generate conduction noise and radiation noise to bring about noise troubles in the equipments in which the circuits are incorporated.

Recent years, international demands for taking stronger countermeasures to such noise troubles have strongly promoted making effort to prevent generation of noise in the equipments in which semiconductor circuits are incorporated.

As one of such countermeasures, it has been practiced, for example, to externally fit a small inductor, called a ferrite bead, on a lead of the rectifiers to be incorporated in semiconductor circuits. The ferrite bead used here is obtained by molding ferrite powder into a toroidal shape followed by sintering. Such a device is known from DE-OS-37 21 427.

This noise suppression device, however, is affected by the properties inherent in the ferrite itself that constitutes the device, to have so small squareness ratio ($Br/B_1$) and saturated magnetic flux density that it can achieve only a small noise-suppressing effect. It hence becomes necessary to make its size larger in order to make effective use thereof. In the instance of this device, it may also occur that the self-loss of ferrite at the time of operation brings about so abrupt heat build-up in the inner diameter side of a hollow center through which the lead of rectifiers is inserted that a great temperature difference is produced between it and the outer diameter side. Because of poorness in the thermal conductivity and heat-dissipation property of the ferrite, this temperature difference may also cause generation of thermal stress in the ferrite bead, which stress may frequently bring about the situation that the ferrite bead is broken. In other words, the ferrite bead can not endure long-term use.

In addition, in the instance where this ferrite bead is used in combination with an inductor of rectifiers or a capacitor and a inductor, the ferrite, which has a high electrical resistance and a small magnetic shielding effect, can not be said to have a sufficient performance in regard to suppression of conduction noise and radiation noise, and thus can not be satisfactory for practical use in regard to its reliability.

Taking account of these, recently developed is a noise suppression device employing a ribbon of an amorphous magnetic alloy.

This device comprises a toroidal core formed by winding an amorphous magnetic alloy ribbon with a given ribbon width so as to give a hollow center with a given inner diameter, coating the whole with a resin such as epoxy resin, and thereafter applying the winding of wire with given turns to the part on which the ribbon has been wound (see e.g. EP-A-4 637 843 and EP-A-4 262 233), and may include devices commercially available under trade names of, for example, "SPIKE KILLER" (produced by Toshiba Corporation).

The above noise suppression device employing the amorphous magnetic alloy ribbon may suffer less breaking troubles in use, is feasible for long-term use, and is superior in the noise suppression performance, but has the following problems in practical use, that are demanded to be solved.

First, it can not be provided by incorporating devices in series in a semiconductor device itself, and, with respect to a printed circuit board prepared after a circuit has been once formed, it also can not be directly incorporated in its circuit, causing the problem that the printed circuit board must be made over. Further, because of relatively large size in shape and dimension, it has a difficulty in regard to a need for space saving, and requires somewhat complicated process in that in its preparation the winding of wire with given turns is applied to the part on which the ribbon has been wound, of the core formed in a toroidal shape by winding the ribbon.

## SUMMARY OF THE INVENTION

An object of this invention is to provide a noise suppression device that is a device in the shape of a toroid but without no winding of wire on the part on which the ribbon has been wound, and yet, because of its specified shape, has been much improved in heat-dissipation properties with a great decrease in the occurence of breaking troubles, and has a superior noise-suppressing effect.

According to the invention from one aspect, there is provided a noise suppression assembly comprising:
(i) an electrical lead; and
(ii) a noise suppression device for use in suppressing noise in said electrical lead, said noise suppression device comprising an amorphous magnetic alloy ribbon wound with plural turns, or a plurality of ring-shaped pieces formed from an amorphous magnetic alloy ribbon and laminated together, in each case to form a toroid-shaped device having a through-hole by means of which the noise suppression device is fitted around said electrical lead with the lead passing through said through hole, the toroid-shaped device having an average diameter Do satisfying the relation $L < Do \leqq 5L$, where said average diameter Do of said toroid shaped device is an arithmetic mean value of the outer diameter of the toroid shaped device and the diameter of the through-hole, and L is the largest dimension of a cross section of said electrical lead, L being smaller than the diameter of the through-hole.

According to the invention from another aspect, there is provided a noise suppression assembly comprising:
(i) a single electrical line; and
(ii) a noise suppression device for use in suppressing noise in said electrical line, said noise suppression device comprising an amorphous magnetic alloy ribbon wound with plural turns, or a plurality of ring-shaped pieces formed from an amorphous magnetic alloy ribbon and laminated together, in each case to form a toroid-shaped device having a through-hole by means of which the noise suppression device is fitted around the electrical line with the line passing through said through-hole, the toroid-shaped device having an average diameter Do satisfying the relation $L < Do \leqq 5L$, where said average diameter Do of said toroid shaped device is an arithmetic mean value of the outer diameter of the toroid shaped device and the diameter of the through-hole, and L is the largest dimension of a cross section of said electrical line, L being smaller than the diameter of the through-hole.

BRIEF DESCRIPTION OF THE DRAWINGS

Fig. 1 is a diagram of a circuit for evaluation of conduction noise;
Fig. 2 is a graph showing the relation between an output noise and a Do/L value when a device having a different Do/L value is incorporated as SAI in the circuit of Fig. 1;
Fig. 3(a) and Fig. 3(b) are views illustrating a rectifier on which the devices have been externally fitted according to this invention, of which Fig. 3(a) is a front view and Fig. 3(b) is a side view;
Fig. 4(a) and Fig. 4(b) are views illustrating a state in which the devices and leads of a rectifier have been integrally formed by molding according to this invention, of which Fig. 4(a) is a front view and Fig. 4(b) is a side view;
Fig. 5 is a graph showing how the temperature rise at the time of operation of devices each having a different D/H and the output noise from a circuit do relate to D/H; and
Fig. 6 is a schematic view of the device of this invention.

DESCRIPTION OF THE PREFERRED EMBODIMENTS

First, the amorphous magnetic alloy ribbon used in preparing the device in the assembly of this invention may include, for example, alloys having the composition represented by the formula:

$$(M_{1 - a}M'_a)_{100 - b}Y_b \quad (I)$$

wherein M represents at least one selected from the group consisting of Fe and Co; M' represents at least one selected from the group consisting of Ti, V, Cr, Mn, Ni, Cu, Zr, Nb, Mo, Ta and W; Y represents at least one selected from the group consisting of B, Si, C and P; and a and b represent numbers satisfying $0 \leqq a \leqq 0.15$ and $10 \leqq b \leqq 35$, respectively.

Of these alloys, preferred are Co-based amorphous magnetic alloys having a saturation magnetostriction of $3 \times 10^{-6}$ or less, more preferably $1 \times 10^{-6}$ or less, as an absolute value, and advantageous are alloys represented by the formula:

$$(Co_{1 - x - y}Fe_xM'_y)_{100 - z}Y_z \quad (II)$$

wherein M' and Y each have the same meaning as in the formula (I), and x, y and z represent numbers satisfying the relation of $0.01 \leqq x \leqq 0.1$, $0 \leqq y \leqq 0.1$ and $10 \leqq z \leqq 32$, respectively.

More preferred alloys may include alloys represented by the formula:

$$(Co_{1 - c - d}Fe_cM''_d)_{100 - f}(Si_{1 - e}B_e)_f \quad (III)$$

wherein M'' represents at least one selected from the group consisting of V, Cr, Mn, Ni, Cu, Nb and Mo; and c, d, e and f represent numbers satisfying $0.01 \leqq c \leqq 0.08$, $0 \leqq d \leqq 0.10$, $0.2 \leqq e \leqq 0.5$ and $20 \leqq f \leqq 30$, respectively.

In these alloys, M, M′ and M″ all are elements effective for improving magnetic characteristics and improving its thermal stability, and alloys containing M′ in excess of 15 atom % may result in a lowering of the Curie point and saturated magnetic flux density thereof. Also, Y is an element essential for making alloys amorphous, but alloys containing it in an amount less than 10 atom % or more than 35 atom % may result in difficulty in making alloys amorphous. Among Y, preferred from the viewpoint of thermal stability is the combination of Si with B as shown in formula (III), where more preferred from the viewpoints of thermal stability and coersive force is that Si is contained in a larger amount than B.

The ribbon made of any of these alloys can be readily prepared in the shape of a ribbon with any desired composition according to the method conventionally used rapidly quenching from the melt. This may also be subjected to suitable heat treatment at a temperature lower than the crystallization temperature, thereby enabling improvement in various properties.

The noise suppression device in the assembly of this invention takes the form of a toroid having a through-hole in its center, and a line in semiconductor circuits or a lead of all sorts of devices such as rectifiers and capacitors is inserted through this through-hole to put it in practical use. In other words, the device is externally fitted by inserting the above line or lead through the through-hole. Accordingly, the through-hole is required to have the diameter such that the above line or lead can be inserted through the hole.

In the device in the assembly of this invention, the average diameter (Do) refers to an arithmetic mean value of the outer diameter of the resulting core and the inner diameter thereof (i.e., diameter of the through-hole) when the above ribbon is wound in the toroidal shape. In this invention, the largest length (L) at a cross section of the line or lead refers to the diameter of a circle when, for example, the cross section of the line or lead is circular, and refers to the length at a diagonal when the cross section of the line or lead is rectangular. The value must be smaller than the diameter of the through-hole as a matter of course.

The device in the assembly of this invention is characterized by designing its Do so as to come to be $L < Do \leqq 5L$, with respect to L of the line or lead to be inserted.

The Do that may otherwise be $Do \leqq L$ results in impossibility of inserting the line or lead through the through-hole of the device, and the Do that may otherwise be $5L \leqq Do$ may result in a lowering of the noise-suppressing effect. Preferably, $1.1L \leqq Do \leqq 4.0L$. Most preferably, $1.1L \leqq Do \leqq 2.0L$.

The device in the assembly of this invention is prepared by winding the above ribbon or laminating ring-shaped pieces formed from the ribbon. In the instance where, for example, it is prepared by winding, first a bobbin having a larger diameter than the value L of the line or lead to be inserted through the through-hole is prepared as a core material, and the above ribbon is wound on this core material with a given number of turns. The winding is stopped when the ribbon has been wound to the thickness that satisfy the average diameter Do having been set in relation to L, and the bobbin is removed after a measure is taken for the ribbon not to be unwound. Thus, there is obtained at the center a core of toroidal shape, having a through-hole that has the same diameter with the diameter of the bobbin and has a given average diameter Do. This core is then subjected to coating on its outer periphery by electrostatic coating, thus obtaining the device of this invention.

In the instance where it is obtained by laminating, it may be practiced to punch out ring-shaped pieces with a given size from the ribbon, laminate an appropriate number of the ring-shaped pieces, and subjecting the resulting laminate to resin-coating treatment. Here, the hollow center formed by the ring-shaped pieces serves as the through-hole. In both instances, these devices are not applied with any further winding of wire thereon.

The device in the assembly of this invention is used in the following manner. Namely, a line in semiconductor circuits or a lead that is lead out of various devices such as rectifiers or capacitors is inserted through the through-hole of the device in the assembly of this invention. In other words, the device is externally fitted by inserting the above line or lead through the through-hole.

In this invention, the ribbon may be wound or ring-shaped pieces formed from the ribbon may be laminated, to give a thickness usually of less than 1.5 mm, preferably not more than 1.3 mm, and more preferably not more than 1.1 mm. In the case where the device comprises laminated ring-shaped pieces, the "thickness" mentioned above refers to a distance from the inner periphery of the ring to the outer periphery thereof.

A preferred embodiment of this invention will be described below. In the noise suppression device of this invention, assuming the thickness given by the wound ribbon or laminated ring-shaped pieces of the ribbon as D, and the height thereof as H, D and H may preferably be in the relation satisfying the formula: $0.03 \leqq D/H \leqq 0.3$.

A method of preparing the noise suppression device in the assembly of this invention according to the above preferred embodiment will be described below. In the instance where, for example, it is prepared by winding, a bobbin having a given diameter is used as a core material, and the ribbon is wound on this core material with a given number of turns. The winding of the ribbon is stopped when the thickness (D) given by the wound ribbon has come to have the thickness satisfying the relation described below, to the width of the ribbon (this width corresponds to the height (H) of the device in a device on which the winding has been applied), and the bobbin is removed after a measure is taken for the ribbon not to be unwound. Thus, there is obtained a core of toroidal shape, having at the center a through-hole that has the same diameter with the diameter of the bobbin and has a height corresponding itself to the width of the ribbon.

This core is then subjected to coating on its outer periphery by electrostatic coating, thus obtaining the device in the assembly of this invention.

Here, D and H are required to satisfy the relation of $0.03 \leqq D/H \leqq 0.3$. The value of D/H otherwise smaller than 0.03 may result in a small noise suppression ability of the resulting device, and the value of D/H otherwise more than 0.3 may cause a lowering of the heat-dissipation properties of the device to make it impossible to disregard the temperature rise of the device at the time of operation. Preferably, D and H may be in such a size that D/H comes to be a value of from 0.05 to 0.25. In regard to H, it may preferably be not more than 8 mm.

In another preferred embodiment of this invention, a ribbon having its surface roughness $R_f$ of not less than 0.2 and not more than 0.8 is used as the above amorphous magnetic alloy ribbon. Here, $R_f$ is a parameter characterizing the roughness determined by $R_f = R_z/T$ when the ten point average roughness in the standard length of 1.5 mm as prescribed in JIS B0601 and an average sheet thickness determined from the weight of the ribbon are assumed as $R_z$ and T, respectively. The $R_f$ otherwise less than 0.2 may result in good adhesion between layers in winding, which causes stress, resulting in deterioration of magnetic properties and making small the noise suppression effect. The $R_f$ otherwise larger than 0.8 makes larger the gap between layers of the magnetic core, resulting in a small total magnetic flux quantity and making small the noise suppression effect.

As a means for bringing the ribbon surface roughness into the scope of this invention, it is necessary to control preparation conditions such as roll meterials, surface temperatures of the roll and ejection temperature of molten metal.

The device in the assembly of this invention can be put into practical use by merely externally fitting it on a line or a lead as described above, but, in embodiments of its use, when it is applied, for example, to a lead of rectifiers or capacitors, not only the device is merely externally fitted by inserting the lead through the through-hole, but also the assembly of this invention comprising the device and the lead may be integrally formed by molding using an electrically insulating synthetic resin. More specifically, various devices in which the device of this invention has been externally fitted may, for example, be placed in a given mold or case, and a resin such as epoxy resin or silicone resin is casted thereinto to make molding. Alternatively, it may be used in the state that it is placed in a protective cover or fixed frame made of a molding resin such as Teflon® and phenol.

Holding the device and the various devices in an integrated form in this manner makes it possible to prevent the device from coming off from the lead when these various devices are handled, and, also when the various devices are incorporated into semiconductor circuit boards, makes it possible to mechanize the operation in incorporating them.

According to the assembly of this invention the device may particularly preferably be applied to leads of diodes and capacitors. In particular, in the instance of diodes, external noise is generated when an abrupt change in electric currents is caused in the diodes, but the device of this invention can suppress it, desirably.

Also, in the instance of capacitors, combination with the device of this invention can constitute a noise filter with ease to provide a countermeasure to noise, desirably.

Example 1

A Co-based amorphous magnetic alloy ribbon having a thickness of 15 μm, a width of 5 mm and the composition of $(Co_{0.94}Fe_{0.05}Nb_{0.01})_{72}Si_{15}B_{13}$ was wound with varied number of turns to prepare toroid-shaped cores having different average diameter Do values. The outer surfaces of these cores were coated with epoxy resin.

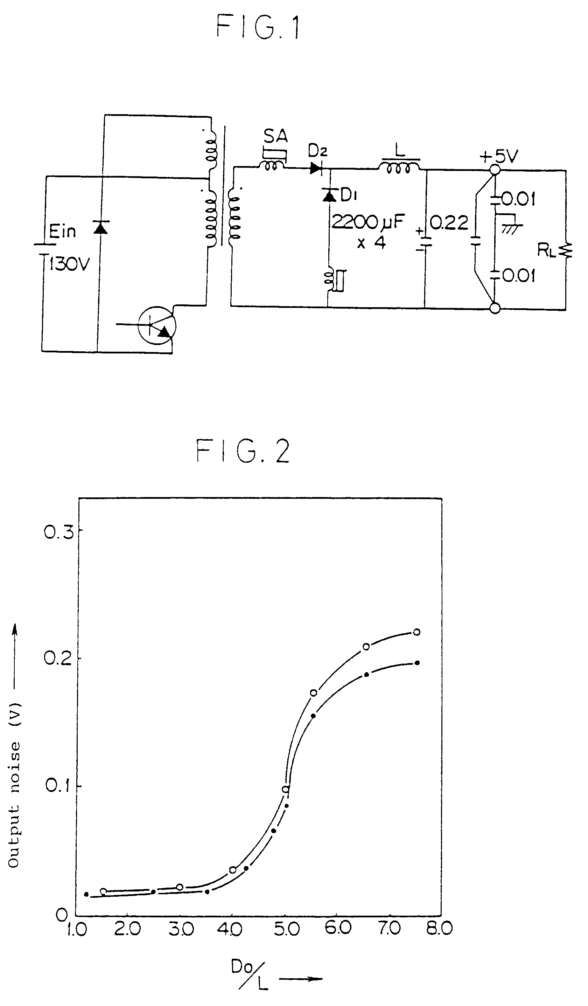

In a conduction noise evaluation circuit as shown in Fig. 1, these devices were used such that a device SAI was externally fitted on a line, or on a lead of a diode D1. In the instance of a line, the line on which SAI was externally fitted through its through-hole was comprised of a wire having a diameter of 2 mm (L = 2), and, in the instance of a diode, the lead of the diode D1 was flat and rectangular in its cross section, which cross section had a largest length (L) of 1.6 mm.

On each of the instances, output noise from the circuit was measured under the test conditions of input voltage Ein: AC 100 V, output voltage E: DC 5 V, output current I: ≃ 8 A, operation frequency f: 200 kHz and L: CY choke, 40 μF - 10 A. Results obtained are shown in Fig. 2 as the relation of Do/L. In the figure, the mark -o- indicates the results obtained when the device was inserted to the line, and the mark -•-, when inserted to the lead.

Example 2

A Co-based amorphous magnetic alloy ribbon having a thickness of 15 μm, a width of 4 mm and the composition of $(Co_{0.94}Fe_{0.05}Nb_{0.01})_{72}Si_{15}B_{13}$ was wound to prepare devices of this invention, each having an outer diameter of 4 mm, an inner diameter (i.e., diameter of the through-hole) of 2 mm, and a height of 4 mm. The outer surfaces of these cores are coated with epoxy resin.

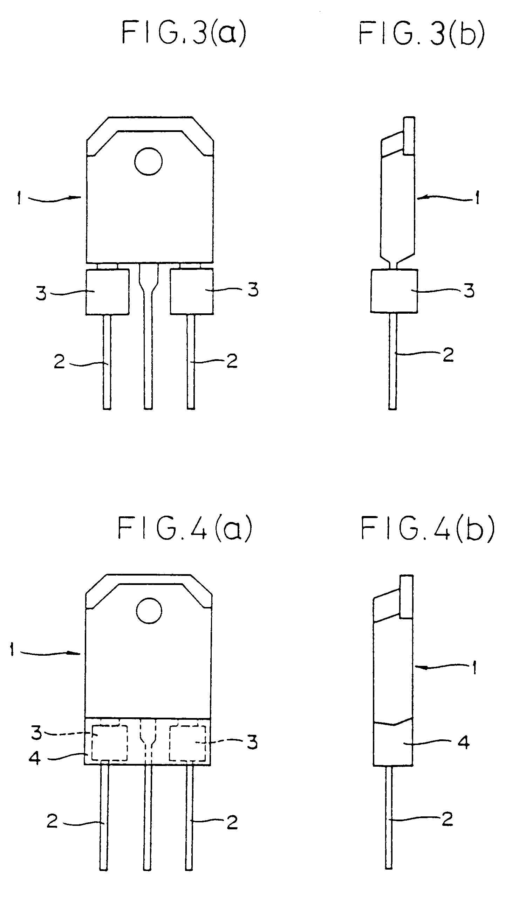

Using a TO3P type diode 1 comprising two pieces of diodes integrally formed in one package as illustrated in Fig. 3(a) and Fig. 3(b), the above devices 3, 3 of this invention was fitted on two leads 2, 2 among three leads of the diode to prepare a diode fitted with inductors. The leads of the diode were rectangular in their cross sections which were 0.5 mm long and 1.6 mm broad and whose largest length (L) was found by calculation to be about 1.68 mm. As another example, as illustrated in Fig. 4(a) and Fig. 4(b), the devices 3, 3 of this invention were fitted on leads 2, 2 of the diode 1, and thereafter the parts at which they were fitted were formed by molding using epoxy resin 4 to bring the both into an integral form.

For comparison, on the other hand, ferrite beads comprising Mn-Zn ferrite and having the same dimension were fitted to a similar diode to prepare a diode fitted with inductors having the same shapes as in the above example of Fig. 3(a) and Fig. 3(b).

The three types of diodes according to the above examples and comparative example were each set on the secondary side of a switching electric source that employs a forward system of 200 kHz. Then, the temperature difference ΔT (°C) between the outer periphery of inductors and the inner periphery thereof fitted on the leads, that causes the breakage of inductors, was measured at the time when a voltage rises concurrently with start of use. Results obtained are shown in Table 1. Temperature in a steady state was also shown similarly in Table 1 as a reference. Provided that environmental temperature was kept constant at 20°C.

Table 1

| | Temperature difference $\Delta T$ at voltage rise ($^{\circ}C$) | Temperature in a steady state ($^{\circ}C$) |
|---|---|---|
| Example 2 | 3 | 30 |
| Comparative example | 9 | 38 |

Also prepared were 100 pieces of samples, respectively for those in which the three types of diodes were each set on the secondary side of a switching electric source, and durability tests were carried out along intermittent use of these under the same conditions over a period of one month. As a result, no break of inductors was seen in the two types of the diodes according to this invention, but, in contrast therewith, breaks of 8 inductors were seen among 100 pieces of the diodes fitted with the ferrite beads.

Next, using as the diode D1 in the conduction noise evaluation circuit shown in Fig. 1 a diode in which the devices of this invention were fitted on its lead and line, output noise from the circuit was measured under the test conditions of input voltage Ein: AC 100 V, output voltage E: DC 5 V, output current I: ≃ 8 A, operation frequency f: 200 kHz and L: CY choke, 40 μF - 10 A. The values obtained were 0.05 V in each instance.

When a diode in which the conventional ferrite bead was fitted on its lead as D1, the output noise was 0.15 V.

Radiation noise generated by these both diodes was further measured using two types of frequencies of 120 MHz and 30 MHz. Results obtained are shown in Table 2.

Table 2

| | Radiation noise (dB) (120 MHz) | Radiation noise (dB) (30 MHz) |
|---|---|---|
| Example 2 | 80 | 100 |
| Comparative example | 115 | 128 |

Example 3

A Co-based amorphous magnetic alloy ribbon having a thickness of 15 μm, a width of 4 mm and the composition of $(Co_{0.94}Fe_{0.05}Nb_{0.01})_{72}Si_{15}B_{13}$ was wound with varied number of turns to prepare toroid-shaped cores having different D values. The cores each had size of 2 mm in inner diameter, 1 mm in thickness D given by the wound ribbon, and 4 mm in height H. The outer surfaces of these cores were coated with epoxy resin.

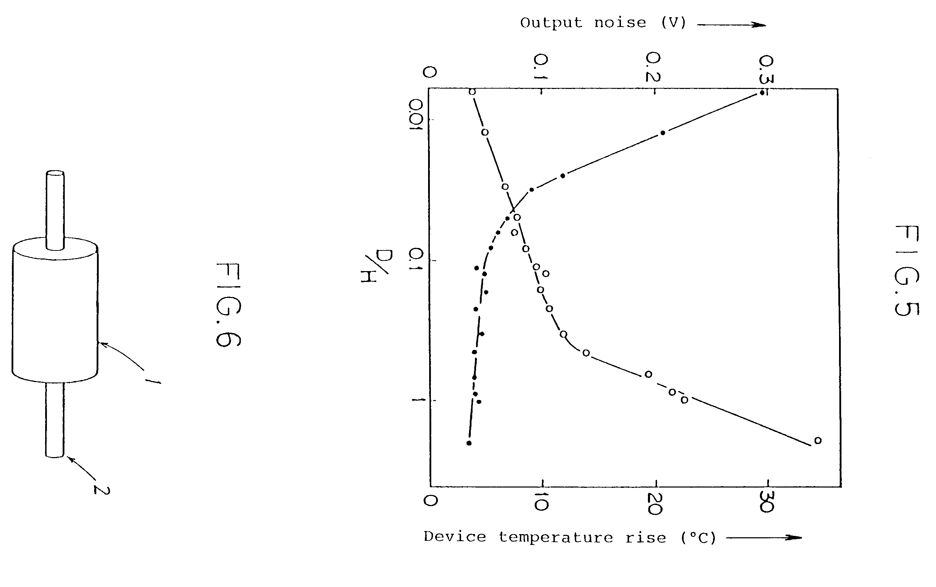

In a conduction noise evaluation circuit as shown in Fig. 1, these devices were used such that a device SAI was externally fitted on a line, or on a lead of a diode D1. On each of the instances, output noise from the circuit was measured under the test conditions of input voltage Ein: AC 100 V, output voltage E: DC 5 V, output current I: ≃ 8 A, operation frequency f: 200 kHz and L: CY choke, 40 μF - 10 A. The leads of the diode were rectangular in their cross sections which were 0.5 mm long and 1.6 mm broad and whose largest length (L) was found by calculation to be about 1.68 mm. Results obtained are shown in Fig. 5 as the relation of D/H. In the figure, the mark -●- indicates output noise, and the mark -o-, temperature rise of device, and each value is expressed as an average value in each D/H.

As will be clear from Fig. 5, when D/H is 0.03 or more the output noise of the circuit is suppressed to a level which is of no problem in practical use, and when it is 0.3 or less the temperature rise of the device comes to be 12°C or less which is of no problem in practical use.

Example 4

A Co-based amorphous magnetic alloy ribbon having a thickness of 15 μm, a width of 4 mm, a surface roughness of $R_f = 0.52$ and the composition of $(Co_{0.94}Fe_{0.05}Nb_{0.01})_{72}Si_{15}B_{13}$ was wound to prepare 1,000 pieces of the device in the assembly of this invention, each having an outer diameter of 4 mm, an inner diameter (i.e., diameter of the through-hole) of 2 mm, and a height of 4 mm. The outer surfaces of these devices are coated with epoxy resin. A schematic view of the device is illustrated in Fig. 6 (in which the numeral 1 denotes a magnetic core; 2, a lead wire).

For comparison, on the other hand, prepared was an amorphous alloy ribbon having the same alloy composition but Rf = 0.11, and also prepared were 1,000 pieces of the device having the same shape.

For comparison, further prepared were inductors comprising Mn-Zn ferrite and having the same shape as in Example 1 above.

Lead wires were all rectangular in their cross sections which were 0.5 mm long and 1.6 mm broad and whose largest length (L) was found by calculation to be about 1.68 mm.

These magnetic cores were used at the position of SAI in the conduction noise evaluation circuit illustrated in Fig. 1, and output noise from the circuit was measured under the test conditions of input voltage Ein: AC 100 V, output voltage E: DC 5 V, output current I: ≃ 8 A, operation frequency f: 200 kHz and L: CY choke, 40 μF - 10 A.

As a result, in examples of this invention, the output noise was stable and as low as 0.04 to 0.06 in all 1,000 pieces, but, in comparative examples in which the amorphous alloy ribbon of $R_f = 0.11$ was used, only about 15 % of the devices attained the output noise of the same level, and the remainder showed an output noise of from 0.12 to 0.15 V.

The comparative examples in which the ferrite was used showed an output noise of from 0.14 to 0.17 V.

As will be clear from the above description, the device of this invention, as being constituted of an alloy material, becomes substantially perfectly free of any breaking troubles, can be used over a long period of time, has superior heat-dissipation properties, and also has superior effect of suppressing the conduction noise or radiation noise of a circuit. Moreover, it can exhibit its function only by externally fitting on a lead of various devices, and hence it has a great industrial value when used as magnetic parts such as simple noise suppression devices and saturable reactors.

**Claims**

1. A noise suppression assembly comprising:
   (i) an electrical lead (2); and
   (ii) a noise suppression device for use in suppressing noise in said electrical lead (2), said noise suppression device comprising an amorphous magnetic alloy ribbon wound with plural turns, or a plurality of ring-shaped pieces formed from an amorphous magnetic alloy ribbon and laminated together, in each case to form a toroid-shaped device (1) having a through-hole by means of which the noise suppression device is fitted around said electrical lead (2) with the lead passing through said through hole, the toroid-shaped device (1) having an average diameter Do satisfying the relation L < Do ≦ 5L, where said average diameter Do of said toroid shaped device (1) is an arithmetic mean value of the outer diameter of the toroid shaped device (1) and the diameter of the through-hole, and L is the largest dimension of a cross section of said electrical lead (2), L being smaller than the diameter of the through-hole.

2. A noise suppression assembly comprising:
   (i) a single electrical line (2); and
   (ii) a noise suppression device for use in suppressing noise in said electrical line (2), said noise suppression device comprising an amorphous magnetic alloy ribbon wound with plural turns, or a plurality of ring-shaped pieces formed from an amorphous magnetic alloy ribbon and laminated together, in each case to form a toroid-shaped device (1) having a through-hole by means of which the noise suppression device is fitted around the electrical line (2) with the line passing through said through-hole, the toroid-shaped device (1) having an average diameter Do satisfying the relation L < Do ≦ 5L, where said average diameter Do of said toroid shaped device (1) is an arithmetic mean value of the outer diameter of the toroid shaped device (1) and the diameter of the through-hole, and L is the largest dimension of a cross section of said electrical line (2), L being smaller than the diameter of the through-hole.

3. The noise suppression assembly according to claim 1 or 2, characterized in that said amorphous alloy ribbon comprises an amorphous magnetic alloy represented by the formula:
$$(M_{1-a}M'_a)_{100-b}Y_b \quad (I)$$
wherein M represents at lease one selected from the group consisting of Fe and Co; M' represents at least one selected from the group consisting of Ti, V, Cr, Mn, Ni, Cu, Zr, Nb, Mo, Ta and W; Y represents at least one selected from the group consisting of B, Si, C and P; and a and b represent numbers satisfying $o \leqq a \leqq 0,15$ and $10 \leqq b \leqq 35$, respectively.

4. The noise suppression assembly according to claim 1 or 2, characterized in that said amorphous alloy ribbon comprises a ribbon of a Co-based amorphous magnetic alloy.

5. The noise suppression assembly according to claim 1 or 2, characterized in that said amorphous alloy ribbon comprises an amorphous magnetic alloy represented by the formula:
$$(Co_{1-x-y}Fe_xM'_y)_{100-z}Y_z \quad (II)$$
wherein M' and Y each have the same meaning as in the formula (I), and x, y and z represent numbers satisfying the relation of $0,01 \leqq x \leqq 0,1$, $0 \leqq y \leqq 0,1$ and $10 \leqq z \leqq 35$, respectively.

6. The noise suppression assembly according to claim 1 or 2, characterized in that said amorphous alloy ribbon comprises an amorphous magnetic alloy represented by the formula:
$$(CO_{1-c-d}Fe_cM''_d)_{100-f}(Si_{1-e}Be)f \quad (III)$$
wherein M'' represents at lease one selected from the group consisting of V, Cr, Mn, Ni, Cu, Nb and Mo; and c, d, e and f represent numbers satisfying $0,01 \leqq c \leqq 0,08$, $0 \leqq d \leqq 0,10$, $0,2 \leqq e \leqq 0,5$ and $20 \leqq f \leqq 30$, respectively.

7. The noise suppression assembly according to any preceding claim, characterized in that, assuming that the thickness given by the wound ribbon or the distance from the inner periphery to the outer periphery of the laminated ring-shaped pieces is "D" and the height thereof is "H", "D" and "H" are in the relation satisfying the formula: $0,03 \leqq D/H \leqq 0,3$.

8. The noise suppression assembly according to claim 1 or 2, characterized in that said ribbon has a surface roughness $R_f$ of not less than 0,2 and not more than 0,8, provided that $R_f$ is a parameter characterizing the roughness determined by $R_f = R_z/T$ when the ten point average roughness in the standard length of 2,5 mm as prescribed in JIS B0601 and an average sheet thickness determined from the weight of the ribbon are assumed as $R_z$ and T, respectively.

9. The noise suppression assembly according to claim 1 or any one of claims 3 to 8 as appended to claim 1, characterized in that the electrical lead (2) is a lead of a rectifier or a capacitor.

10. The noise suppression assembly according to any preceding claim, characterized in that a coating is applied on the outside of said toroid-shaped device (1) by moulding, so that the electrical lead or line (2) to which the noise suppression device is applied and the toroid-shaped device (1) are integrally formed by the moulded coating.

11. The noise suppression assembly according to any preceding claim, characterized in that the amorphous magnetic alloy ribbon is an alloy thin ribbon obtained by quenching.


**Patentansprüche**

1. Rauschunterdrückungs-Baugruppe, umfassend:
   (i) eine elektrische Zuleitung (2); und
   (ii) eine Rauschunterdrückungseinrichtung zur Verwendung zur Rauschunterdrückung in der elektrischen Zuleitung (2), wobei die Rauschunterdrückungseinrichtung umfaßt: ein mit mehreren Windungen gewickeltes Band aus einer amorphen magnetischen Legierung, oder eine Vielzahl von ringförmigen Stücken, die aus einem Band aus einer amorphen magnetischen Legierung gebildet und zusammenlaminiert sind, in jedem Fall zur Bildung einer torosförmigen Einrichtung (1) mit einem Durchloch, mit dem die Rauschunterdrückungseinrichtung um die elektrische Zuleitung (2) angebracht wird, wobei die Zuleitung durch das Durchloch läuft, wobei die torosförmige Einrichtung (1) einen durchschnittlichen Durchmesser Do aufweist, der die Beziehung L < Do $\leqq$ 5L erfüllt, wobei der durchschnittliche Durchmesser Do der torosförmigen Einrichtung (1) ein arithmetischer Mittelwert des äußeren Durchmessers der torosförmigen Einrichtung (1) und des Durchmessers des Durchlochs ist, und L die größte Abmessung eines Querschnitts der elektrischen Zuleitung (2) ist, wobei L kleiner als der Durchmesser des Durchlochs ist.

2. Rauschunterdrückungs-Baugruppe, umfassend:
   (i) eine einzige elektrische Leitung (2); und
   (ii) eine Rauschunterdrückungseinrichtung zur Verwendung zur Rauschunterdrückung in der elektrischen Leitung (2), wobei die Rauschunterdrückungseinrichtung umfaßt: ein mit mehreren Wicklungen gewickeltes Band aus einer amorphen magnetischen Legierung, oder eine Vielzahl von ringförmigen Stücken, die aus einem Band aus einer amorphen magnetischen Legierung gebildet und zusammenlaminiert sind, in jedem Fall zur Bildung einer torosförmigen Einrichtung (1) mit einem Durchloch, mit dem die Rauschunterdrückungseinrichtung um die elektrische Leitung (2) herum angebracht wird, wobei die Leitung durch das Durchloch läuft, die torosförmige Einrichtung (1) einen durchschnittlichen Durchmesser Do aufweist, der die Beziehung L < Do $\leqq$ 5L erfüllt, wobei der durchschnittliche Durchmesser Do der torosförmigen Einrichtung (1) ein arithmetischer Durchschnittswert des äußeren Durchmessers der torosförmigen Einrichtung (1) und des Durchmessers des Durchlochs ist und L die größte Abmessung eines Querschnitts der elektrischen Leitung (2) ist, wobei L kleiner als der Durchmesser des Durchlochs ist.

3. Rauschunterdrückungs-Baugruppe nach Anspruch 1 oder 2,
   dadurch **gekennzeichnet**, daß das Band aus einer amorphen Legierung eine amorphe magnetische Legierung umfaßt, die durch die folgende Formel dargestellt ist:
   $$(M_{1-a}M'_a)_{100-b}Y_b \quad (I)$$
   wobei M wenigstens ein Material gewählt aus der Gruppe bestehend aus Fe und Co darstellt; M' wenigstens ein Material gewählt aus der Gruppe bestehend aus Ti, V, Cr, Mn, Ni, Cu, Zr, Nb, Mo, Ta und W darstellt; Y wenigstens ein Material gewählt aus der Gruppe bestehend aus B, Si, C und P darstellt; und a und b Zahlen darstellen, die jeweils die Beziehung o $\leqq$ a $\leqq$ 0,15 und 10 $\leqq$ b $\leqq$ 35 erfüllen.

4. Rauschunterdrückungs-Baugruppe nach Anspruch 1 oder 2,

dadurch **gekennzeichnet**, daß das Band aus der amorphen Legierung ein Band aus einer amorphen magnetischen Legierung auf Co-Basis umfaßt.

5. Rauschunterdrückungs-Baugruppe nach Anspruch 1 oder 2,
dadurch **gekennzeichnet**, daß das Band aus der amorphen Legierung eine amorphe magnetische Legierung umfaßt, die durch die folgende Formel dargestellt ist:

$$(Co_{1-x-y}Fe_xM'_y)_{100-z}Y_z \quad (II)$$

wobei M′ und Y jeweils die gleiche Bedeutung wie in der Formel (I) besitzen, und x, y und z Zahlen darstellen, die jeweils die Beziehung $0,01 \leqq x \leqq 0,1$, $0 \leqq y \leqq 0,1$ und $10 \leqq z \leqq 32$ erfüllen.

6. Rauschunterdrückungs-Baugruppe nach Anspruch 1 oder 2,
dadurch **gekennzeichnet**, daß das Band aus der amorphen Legierung eine amorphe magnetische Legierung umfaßt, die durch die folgende Formel dargestellt wird:

$$(Co_{1-c-d}Fe_cM''_d)_{100-f}(Si_{1-e}B_e)_f \quad (III)$$

wobei M″ wenigstens ein Material gewählt aus der Gruppe bestehend aus V, Cr, Mn, Ni, Cu, Nb und Mo darstelltn; und c, d, e und f Zahlen darstellen, die jeweils die Beziehung $0,01 \leqq c \leqq 0,08$, $0 \leqq d \leqq 0,10$, $0,2 \leqq e \leqq 0,5$ und $20 \leqq f \leqq 30$ erfüllen.

7. Rauschunterdrückungs-Baugruppe nach einem der vorangehenden Ansprüche,
dadurch **gekennzeichnet**, daß unter der Annahme, daß die durch das gewickelte Band gegebene Dicke oder der Abstand von dem inneren Umfang zu dem äußeren Umfang der laminierten ringförmigen Stücke "D" und die Höhe davon "H" ist, "D" und "H" in der Beziehung sind, die die folgende Formel erfüllt: $0,03 \leqq D/H \leqq 0,3$.

8. Rauschunterdrückungs-Baugruppe nach Anspruch 1 oder 2,
dadurch **gekennzeichnet**, daß das Band eine Oberflächenrauhigkeit $R_f$ von weniger als 0,2 oder nicht mehr als 0,8 aufweist, vorausgesetzt, daß $R_f$ ein Parameter ist, der die durch $R_f = R_z/T$ bestimmte Rauhigkeit charakterisiert, wenn die Zehnpunkt-Durchschnittsrauhigkeit in der Standardlänge von 2,5 mm wie in dem JIS B 0601 vorgeschrieben und eine aus dem Gewicht des Bandes bestimmte durchschnittliche Blattdicke als $R_z$ bzw. T angenommen wird.

9. Rauschunterdrückungs-Baugruppe nach Anspruch 1 oder einem der Ansprüche 3 bis 8, so wie sie an Anspruch 1 angehängt sind,
dadurch **gekennzeichnet**, daß die elektrische Zuleitung (2) eine Zuleitung eines Gleichrichters und eines Kondensators ist.

10. Rauschunterdrückungs-Baugruppe nach einem der vorangehenden Ansprüche,
dadurch **gekennzeichnet**, daß auf die Außenseite der torosförmigen Einrichtung durch Vergießen eine Beschichtung angebracht wird, so daß die elektrische Zuleitung oder Leitung (2), auf die die Rauschunterdrückungseinrichtung angebracht ist, und die torosförmige Einrichtung (1) durch die vergossene Beschichtung integral gebildet werden.

11. Rauschunterdrückungs-Baugruppe nach einem der vorangehenden Ansprüche,
dadurch **gekennzeichnet**, daß das Band aus der amorphen magnetischen Legierung ein dünnes Legierungsband ist, welches durch Abschrecken erhalten wird.

## Revendications

1. Assemblage antibruit comportant :
(i) un conducteur électrique (2); et
(ii) un dispositif antibruit destiné à supprimer un bruit dans ce conducteur électrique (2), ce dispositif antibruit comportant un ruban en alliage magnétique amorphe, enroulé avec plusieurs tours, ou plusieurs pièces en forme d'anneaux formées à partir d'un ruban en alliage magnétique amorphe et laminées ensemble pour former dans chaque cas un ensemble de forme toroïdale (1) ayant un trou de passage par lequel le dispositif antibruit est fixé autour du dit conducteur électrique (2) avec le fil passant au travers du trou, cet ensemble de forme toroïdale (1) ayant un diamètre moyen Do, satisfaisant la relation $L < Do \leqq 5L$, où ledit diamètre Do de l'ensemble de forme toroïdale(1) est une valeur moyenne arithmétique du diamètre externe de cet ensemble (1) et du trou de passage, L étant la plus grande dimension d'une section transversale du conducteur électrique (2), et plus petite que le diamètre du trou de passage.

2. Assemblage antibruit comportant :
   (i) une ligne électrique unifilaire (2); et
   (ii) un dispositif antibruit pour supprimer un bruit dans cette ligne électrique (2), ce dispositif antibruit comportant un ruban en alliage magnétique amorphe, enroulé avec plusieurs tours, ou plusieurs pièces en forme d'anneaux formées à partir d'un ruban en alliage magnétique amorphe et laminées ensemble pour former dans chaque cas un ensemble de forme toroïdale (1) ayant un trou de passage par lequel le dispositif antibruit est fixé autour de la ligne électrique (2) avec la ligne passant au travers du trou, cet ensemble de forme toroïdale (1) ayant un diamètre moyen, satisfaisant la relation L < Do ≦ 5L, où ledit diamètre Do de l'ensemble de forme toroïdale (1) est une valeur moyenne arithmétique du diamètre externe de cet ensemble (1) et du diamètre du trou de passage, L étant la plus grande dimension d'une section transversale de la ligne électrique (2), et plus petite que le diamètre du trou de passage.

3. Assemblage antibruit selon la revendication 1 ou 2, caractérisé en ce que le ruban en alliage amorphe comporte un alliage magnétique amorphe, de formule :
$$(M_{1-a}M'_a)_{100-b}Y_b \quad \text{(I)}$$
où M représente au moins une sélection parmi le groupe constitué du Fe et Co; M' représente au moins une sélection parmi le groupe constitué du Ti, V, Cr, Mn, Ni, Cu, Zr, Nb, Mo, Ta et W; Y représente au moins une sélection parmi le groupe constitué du B, Si, C et P; et a et b représentent des nombres satisfaisant respectivement $0 \leqq a \leqq 0.15$ et $10 \leqq b \leqq 35$.

4. Assemblage antibruit selon la revendication 1 ou 2, caractérisé en ce que le ruban en alliage amorphe comporte un alliage à base de Co.

5. Assemblage antibruit selon la revendication 1 ou 2, caractérisé en ce que le ruban en alliage amorphe comporte un alliage de la formule :
$$(Co_{1-x-y}Fe_xM'_y)_{100-z}Y_z \quad \text{(II)}$$
où M' et Y ont chacun la même signification que dans la formule (I), et x, y et z représentent des nombres satisfaisant respectivement les relations $0,01 \leqq x \leqq 0,1$, $0 \leqq y \leqq 0,1$ et $10 \leqq z \leqq 35$.

6. Assemblage antibruit selon la revendication 1 ou 2, caractérisé en ce que le ruban en alliage amorphe comporte un alliage de la formule :
$$(Co_{1-c-d}Fe_cM''_d)_{100-f}(Si_{1-e}B_e)f \quad \text{(III)}$$
où M'' représente au moins une sélection parmi le groupe constitué du V, Cr, Mn, Ni, Cu, Nb et Mo; et c, d, e et f représentent des nombres satisfaisant respectivement $0,01 \leqq c \leqq 0,08$, $0 \leqq d \leqq 0,10$, $0,2 \leqq e \leqq 0,5$ et $20 \leqq f \leqq 30$.

7. Assemblage antibruit selon l'une quelconque des revendications précédentes, caractérisé en ce que, en supposant que l'épaisseur donnée par le ruban enroulé ou la distance de la périphérie interne à la périphérie externe de pièces en forme d'anneaux laminées soit "D" et que la hauteur soit "H", "D" et "H" sont dans une relation satisfaisant la formule : $0,03 \leqq D/H \leqq 0,3$.

8. Assemblage antibruit selon la revendication 1 ou 2, caractérisé en ce que le ruban a une rugosité de surface $R_f$ de au moins 0.2 et au plus 0.8, sous réserve que $R_f$ soit un paramètre caractérisant la rugosité déterminée par $R_f = R_z/T$, lorsque la rugosité moyenne de dix points selon la longueur normalisée de 2.5 mm comme prescrite dans la norme JIS B0601 et l'épaisseur moyenne de feuille déterminée à partir du poids du ruban, sont respectivement $R_z$ et T.

9. Assemblage antibruit selon la revendication 1 ou l'une quelconque des revendications 3 à 8 dépendant de la revendication 1, caractérisé en ce que le conducteur électrique (2) est un fil d'un redresseur ou d'un condensateur.

10. Assemblage antibruit selon l'une quelconque des revendications précédentes, caractérisé en ce qu'un enduit est appliqué sur l'extérieur de l'ensemble de forme toroïdale (1) par moulage, de sorte que le conducteur ou la ligne électrique (2) auquel est appliqué le dispositif antibruit et l'ensemble de forme toroïdale (1), font partie intégrante grâce à cet enduit.

11. Assemblage antibruit selon une quelconque des revendications précédentes, caractérisé en ce que le ruban en alliage magnétique amorphe est un ruban fin, obtenu par trempe.

FIG.1

FIG.2

FIG.3(a)

FIG.3(b)

FIG.4(a)

FIG.4(b)

# FIG.5

# FIG.6